# EUROPEAN PATENT SPECIFICATION

(11) **EP 3 366 809 B1**
(45) Date of publication and mention of the grant of the patent: **15.03.2023**
(21) Application number: 15906616.6
(22) Date of filing: 19.10.2015
(51) Int. Cl.: C23C 16/04, C23C 16/44, C23C 16/455, C23C 16/509, H01J 37/32, B65D 23/02

(54) **FILM FORMING DEVICE**
VORRICHTUNG ZUR FILMFORMUNG
DISPOSITIF DE FORMATION DE FILM

(43) Date of publication of application: 29.08.2018
(73) Proprietor: Mitsubishi Heavy Industries Machinery Systems, Ltd., Hyogo-ku Kobe-shi Hyogo 652-8585 (JP)
(72) Inventor: MIZUKAWA, Kenji, Nagoya-shi Aichi 453-0862 (JP); HIROYA, Kiyoshi, Nagoya-shi Aichi 453-0862 (JP); NAKANISHI, Fumikazu, Nagoya-shi Aichi 453-0862 (JP)
(74) Representative: Hoffmann Eitle
(86) International application number: PCT/JP2015/005258
(87) International publication number: WO 2017/068608

(56) References cited:
- EP-A1- 2 642 506
- EP-A1- 2 799 593
- WO-A1-95/21948
- JP-A- 2013 133 494
- JP-A- 2013 133 494
- JP-A- 2013 197 594

## Description

### Technical Field

The present invention relates to a film forming device which is preferable to form a film having gas barrier properties in a resin container.

### Background Art

In resin containers, a film having gas barrier properties has been formed on their inner peripheral surfaces. This film having gas barrier properties is formed for several purposes. For example, the film aims to prevent oxygen from permeating into the container from outside and to ensure the quality of a product liquid filling the container. In addition, the film aims to prevent carbon dioxide contained in carbonated drinks from permeating out via the container.

As a film having gas barrier properties (hereinafter, will be referred to as a barrier film), as disclosed in JP2008-231468A and WO2012-91097A1, various kinds of films including hard carbon films such as diamond-like carbon (DLC), and silica (SiO₂) films, and the like have been proposed.

These barrier films can be formed through various methods. A chemical vapor deposition (CVD) method is one of the representative film-forming methods, and a plasma CVD method is known as a typical example among thereof (JP2008-231468A). In the plasma CVD method, a medium gas (raw material) is decomposed by means of plasma and is ionized in a film-forming chamber in a vacuum state, and ions accelerated by an electric field collide with each other, thereby forming a film.

WO2012-91097A1 and WO2013-99960A1 disclose a catalytic chemical vapor deposition (Cat-CVD) method which is known as an alternative CVD method other than the plasma CVD method. In the Cat-CVD method, a medium gas is decomposed on a surface of a linear heat generating body or a catalytic body which has been energized and heated inside a film-forming chamber, and generated chemical species are deposited directly or after undergoing a reaction process in a gas phase, thereby forming a film. The Cat-CVD method is also referred to as a heat generating body CVD method or a hot wire CVD method.

In regard to the Cat-CVD method, WO2013-99960A1 discloses a film forming device including a vacuum chamber which performs film-forming using a heat generating body on a surface of a container in a vacuum state, vacuum exhaust means for performing vacuum drawing of the vacuum chamber, and relative movement means for causing the container and the heat generating body to relatively move inside the vacuum chamber after vacuum drawing of the vacuum chamber starts. According to the film forming device of Wü2013-99960A1, a place which can be a restriction of a film-forming time from the viewpoint of thermal deformation can be subjected to film-forming only for a short period of time, and other parts can be sufficiently subjected to film-forming. As a result, barrier properties of the entire container can be easily improved.

As described above, in the Cat-CVD method, a linear heat generating body generates heat by being energized inside the film-forming chamber when film-forming is performed. In order to efficiently decompose the medium gas, the temperature of heat-generation is set within a range from 1, 550°C to 2,400°C. Therefore, the heat generating body is formed of a material containing one or more metallic elements selected from the group consisting of tungsten (W), molybdenum (Mo), zirconium (Zr), tantalum (Ta), vanadium (V), niobium (Nb), and hafnium (Hf) known as high-melting metals. As the material, a pure metal, an alloy, or a metal carbide formed of the metallic elements can be selected. Among the metallic elements, a material containing one or more metallic elements selected from the group consisting of Mo, W, Zr, and Ta is preferably employed.

Further, JP 2013 133 494 A describes a source gas supply mechanism of thin film, which aims to provide an improved source gas supply mechanism of a thin film suitably used in a film forming apparatus which forms a thin film on the inner surface of an inverted PET bottle.

### Summary of Invention

### Technical Problem

In a Cat-CVD method, a heat generating body and a gas supply pipe supplying a medium gas toward the heat generating body are inserted into a container which is accommodated in a vacuum chamber subjected to vacuum drawing, and the medium gas is supplied from a tip end of the gas supply pipe. In this manner, in the Cat-CVD method, since the gas supply pipe is inserted and evulsed with respect to the vacuum chamber, a connection part between a supply source of the medium gas and the gas supply pipe is required to cope with the advance and retreat.

A gas supply pipe formed of a flexible material such as rubber and a synthetic resin can cope with forward/rearward movement. However, since the gas supply pipe has a bit of ventilation properties, the medium gas leaks out of the gas supply pipe. Then, there is concern that the required medium gas cannot be supplied to the heat generating body.

Therefore, an object of the present invention is to provide a film forming device including a gas supply pipe which can supply a medium gas toward a heat generating body without leaking when being inserted into a vacuum chamber.

### Solution to Problem

According to the present invention made based on the object, there is provided a film forming device including a chamber which has a film-forming chamber accommodating a container for forming a gas barrier film, and in which the film-forming chamber is in a vacuum state when the gas barrier film is formed; a gas supply pipe which has a first gas flow channel introducing a medium gas used for forming the gas barrier film into the container and moves upward and downward along an axis line direction thereof; a cylinder in which the gas supply pipe moves upward and downward; and a heat generating body which generates heat when power is supplied.

According to the present invention, the cylinder has an gas supply port through which the medium gas is supplied from outside. The gas supply pipe includes a second gas flow channel which moves upward and downward between a film-forming position where film-forming is performed and a standby position where no film-forming is performed, and causes the gas supply port of the cylinder and the first gas flow channel to be in communication with each other at the film-forming position.
Further, the film forming device further includes a shielding gate which blocks communication between the film-forming chamber and the pressure-reducing chamber when the gas supply pipe is retreated from the film-forming chamber.

According to the film forming device of the present invention, since the gas supply pipe and the cylinder behave as a piston-cylinder mechanism and these members can be produced with a raw material such as a metallic material allowing no gas to pass through, the medium gas can be prevented from leaking. Furthermore, according to the present invention, since the gas supply pipe includes the second gas flow channel which causes the gas supply port of the cylinder and the first gas flow channel to be in communication with each other at the film-forming position, the medium gas can be supplied to a required place when film-forming is performed.

In the film forming device of the present invention, the second gas flow channel is provided in a seal which is fitted into the gas supply pipe and is slidably pressed to the cylinder.

In a case where the seal includes a first seal ring, a second seal ring which is provided at a distance from the first seal ring in the axis line direction, and a spacer which is provided between the first seal ring and the second seal ring and has a diameter smaller than diameters of the first seal ring and the second seal ring, the second gas flow channel is provided in the spacer.

According to the present invention, the film forming device may further include a heat generating unit which is supported by the gas supply pipe. It is preferable that the heat generating unit has the heat generating body which generates heat when power is supplied and a pair of leads which is electrically connected to the heat generating body.

In the film forming device of the present invention, the gas supply pipe may retreat from the film-forming chamber and be accommodated in the cylinder while being on standby before gas barrier film is formed, and the first gas flow channel may be subjected to vacuum drawing.

In the film forming device of the present invention, it is preferable that the medium gas is supplied to the film-forming chamber via the gas supply pipe continuously as much as a predetermined period of time after forming of the gas barrier film ends.

In the film forming device of the present invention, it is preferable that the medium gas is supplied to the pressure-reducing chamber between the gas supply pipe and the cylinder via the gas supply port while being on standby before forming of the gas barrier film is performed.

### Advantageous Effects of Invention

According to the present invention, since the gas supply pipe includes the second gas flow channel which causes the gas supply port of the cylinder and the first gas flow channel to be in communication with each other at the film-forming position, the medium gas can be supplied to the container. In this manner, since the gas supply pipe and the cylinder behave as a piston-cylinder mechanism and corresponding members can be produced with a raw material such as a metallic material allowing no gas to pass through, the medium gas can be prevented from leaking. As a result, the medium gas can be supplied toward the heat generating body without leaking.

### Brief Description of Drawings

Figs. 1A and 1B are longitudinal sectional views illustrating a schematic configuration of a film forming device according to an embodiment. Fig. 1A illustrates a standby state before film-forming or after film-forming, and Fig. 1B illustrates a film-forming state.
Figs. 2A to 2C illustrate the film forming device of Fig. 1. Fig. 2A is an exploded view, Fig. 2B is a partially enlarged view of the standby state of Fig. 2A, and Fig. 2C is a partially enlarged view of the film-forming state of Fig. 2A.
Fig. 3A illustrates a step of container supplying, Fig. 3B illustrates a step of vacuum drawing and gas scavenging, and Fig. 3C illustrates a step of gate opening and nozzle lowering, in the procedure of Fig. 6.
Figs. 4A and 4B illustrate a step of film-forming (start of film-forming and completion of film-forming), and Fig. 4C illustrates a step of nozzle raising and gate closing, in the procedure of Fig. 6.
Fig. 5A illustrates a step of atmosphere exposing, and Fig. 5B illustrates a step of container discharging, in the procedure of Fig. 6.
Fig. 6 is a flow chart illustrating a procedure of forming a barrier film in a container by using the film forming device of the present embodiment.

### Description of Embodiment

Hereinafter, the invention will be described in detail based on an embodiment illustrated in the accompanying drawings.

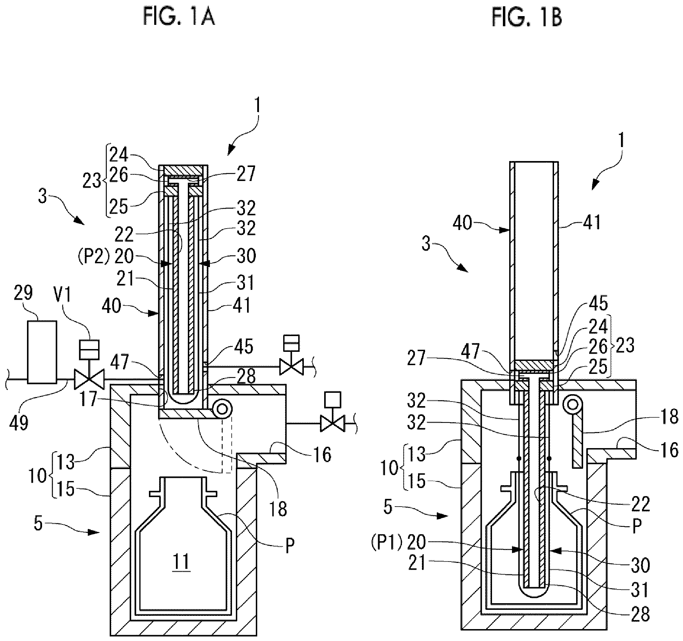

According to the present embodiment illustrated in Figs. 1A and 1B, a film forming device 1 forms a gas barrier film on an inner surface of a resin container P through a Cat-CVD method and is configured to prevent oxidation of a heat generating unit 30.

For example, the film forming device 1 is applied to a system in which the container P is filled with drinks. As an example, this system can include a container forming portion that forms the container P, a film-forming portion that forms a barrier film on an inner peripheral surface of the formed container P, a filling portion that causes a filling gap of the container P in which the barrier film is formed on the inner peripheral surface to be filled with drinks, and a capping portion that puts a cap on the resin container filled with the drinks. In this beverage filling system, each of the elements including the container forming portion, the film-forming portion, the filling portion, and the capping portion is configured to be a rotary mechanism. A transfer device for delivering the container P can be provided between the elements. However, the film forming device 1 can employ a batch-type configuration.

As illustrated in Figs. 1A and 1B, the film forming device 1 includes a film-forming portion 3 that forms a barrier film in the resin container P, and a gas transportation portion 5 that transports a medium gas G to the film-forming portion 3.

The film-forming portion 3 includes a vacuum chamber 10 as a main constituent element. In addition, the gas transportation portion 5 includes a gas supply pipe 20 that is disposed inside the container P so as to be insertable and removable and supplies a medium gas to the inside of the container P, and a cylinder 40 that accommodates the gas supply pipe 20, as main constituent elements.

Hereinafter, the constituent elements of the film forming device 1 will be described in order.

### [Vacuum Chamber 10]

The vacuum chamber 10 provided in the film-forming portion 3 includes a cylindrical lower chamber 15 of which one end (upper end) in an axial direction is open, and an upper chamber 13 which is mounted on an upper portion of the lower chamber 15 so as to be attachable and detachable with respect to the lower chamber 15. In the vacuum chamber 10, an internal space formed by the lower chamber 15 and the upper chamber 13 accommodates the container P and configures a film-forming chamber 11 forming a barrier film.

In the present embodiment, the container P is accommodated in the lower chamber 15. The container P is carried into and carried out from the lower chamber 15 through an opening (entry way) formed at an upper end of the lower chamber 15. Therefore, the internal space of the lower chamber 15 is formed to be slightly larger than the outer shape of the container P to be accommodated therein. In the upper chamber 13, when the container P is carried into the lower chamber 15, the entry way is closed. In addition, when the container P is carried into and carried out from the lower chamber 15, the entry way is opened. In the present embodiment, the position of the upper chamber 13 in a vertical direction (upward-downward direction in Figs. 1A and 1B) is fixed, and the lower chamber 15 moves upward and downward as indicated with the double-headed arrows by an actuator (not illustrated). However, a reversed configuration may be employed as long as the lower chamber 15 and the upper chamber 13 relatively move and the film-forming chamber 11 is sealed and exposed. In order to ensure a sealing state between the lower chamber 15 and the upper chamber 13, a seal material such as an O-ring can be provided between both the chambers.

The upper chamber 13 includes an exhaust passage 16. In this exhaust passage 16, one end is in communication with the entry way of the lower chamber 15 and the other end is connected to an exhaust pump (not illustrated). When the lower chamber 15 and the upper chamber 13 are in a sealed state and the exhaust pump operates, gas components inside the film-forming chamber 11 and the container P are discharged, so that the film-forming chamber 11 and the container P are in a pressure-reduced state, and preferably in a vacuum state. The aforementioned term "pressure-reduced" denotes a state of pressure lower than the atmospheric pressure.

In the upper chamber 13, a through-window 17 in which the gas supply pipe 20 and the heat generating unit 30 advance and retreat is provided so as to penetrate a top wall of the upper chamber 13. A tip portion of the cylinder 40 is inserted into the through-window 17 so as to reach the film-forming chamber 11 and is fixed to the upper chamber 13. The gas supply pipe 20 and the heat generating unit 30 advance and retreat in the through-window 17 through the inside of the cylinder 40.

A tool which is also referred to as a gripper for gripping the container P is provided inside the vacuum chamber 10. A barrier film can be formed while a neck part of the container P is gripped by the gripper.

The upper chamber 13 supports the cylinder 40. In the cylinder 40, one end positioned below thereof penetrates the front and the rear of the upper chamber 13 and is fixed to the upper chamber 13. A pressure-reducing chamber 43 inside thereof is in communication with the film-forming chamber 11. However, an oscillating-type shielding gate 18 which opens and closes the opening of the cylinder 40 leading to the film-forming chamber 11 is provided in the exhaust passage 16 of the upper chamber 13. When the shielding gate 18 is closed, the pressure-reducing chamber 43 of the cylinder 40 forms a closed space. More specific configuration of the cylinder 40 will be described below.

It is preferable that a structure for causing cooling water to circulate is provided in one or both the inside and outside of the vacuum chamber 10 so as to prevent a temperature rise of the lower chamber 15 and the upper chamber 13. It is preferable that this cooling structure is provided particularly for the lower chamber 15 because the container P, in which the heat generating unit 30 serving as a heat source when forming a barrier film is inserted, is just accommodated in the lower chamber 15.

In addition, in the vacuum chamber 10, it is preferable that the inner surfaces of the lower chamber 15 and the upper chamber 13 facing the film-forming chamber 11 are subjected to processing for preventing reflection of light emitted in accordance with heat generation of the heat generating unit 30. As this processing, for example, it is considered that the inner surfaces are colored in black or fine uneven surfaces are employed. Accordingly, a temperature rise of the container P can be suppressed.

A material configuring the vacuum chamber 10 is arbitrary as long as the material has predetermined properties such as heat resistance and corrosion resistance. An aluminum alloy can be preferably used.

### [Gas Supply Pipe 20]

Subsequently, the gas supply pipe 20 configuring the gas transportation portion 5 introduces the medium gas G stored in a raw material tank 29 into the film-forming chamber 11 of the vacuum chamber 10. The gas supply pipe 20 is supported so as to be movable upward and downward along an axis line direction by an actuator (not illustrated) between a film-forming position P1 (Fig. 1B) at the time of forming a barrier film and a standby position P2 (Fig. 1A) at the time of being on standby during which no film is formed.

As illustrated in Figs. 1A and 1B, the gas supply pipe 20 includes a pipe main body 21 in which a first gas flow channel 22 penetrating the pipe main body 21 in the axial direction is formed, and a seal 23 which is fitted into an upper end of the pipe main body 21. Since the seal 23 is in tight contact with an inner wall of the cylinder 40 (will be described below), the gas supply pipe 20 is slidably supported by the cylinder 40 and can move upward and downward while ensuring its vertical air-tight properties having the seal 23 as a border.

In the pipe main body 21, one end side (lower end side) is open, and the medium gas G is discharged toward a heat generating body 31 from this opening in the film-forming state. Hereinafter, the tip end part having this opening is also referred to as a nozzle 28.

In the pipe main body 21, the other end side (upper end side) is connected to the seal 23, and the medium gas supplied via the cylinder 40 flows into the pipe main body 21 through the seal 23.

The seal 23 includes a first seal ring 24 disposed on an upper side, a second seal ring 25 disposed on a lower side at a distance from the first seal ring 24, and a spacer 26 disposed between the first seal ring 24 and the second seal ring 25. The first seal ring 24 and the second seal ring 25 are disk-shaped members which can be sealed in tight contact with the inner peripheral surface of the cylinder 40, made of the same material, and have the same dimension. The spacer 26 is a disk-shaped member having a diameter smaller than the diameters of the first seal ring 24 and the second seal ring 25, and the T-shaped second gas flow channel 27 is formed therein. In this second gas flow channel 27, one end is open on the outer peripheral surface of the spacer 26 and the other end is open on a lower end surface of the spacer 26, thereby being in communication with the first gas flow channel 22 of the pipe main body 21.

The heat generating unit 30 (will be described below) is supported by the second seal ring 25. The gap around the spacer 26 also configures a part of the second gas flow channel of the present invention.

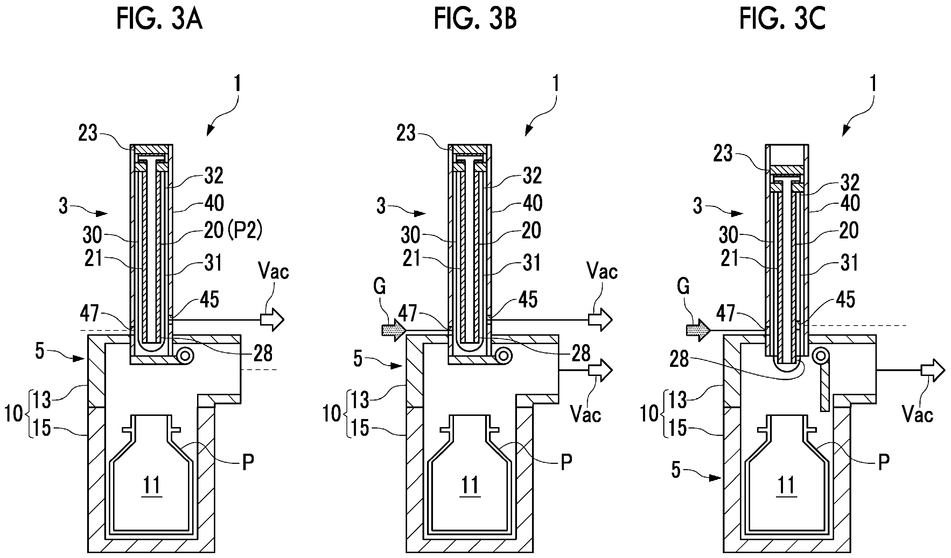

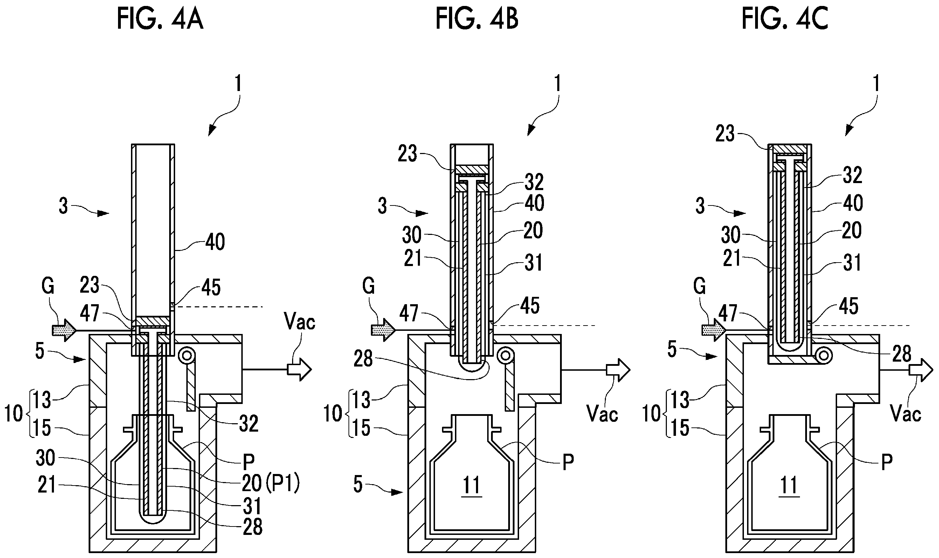

In the gas supply pipe 20, the most part of the pipe main body 21 including the seal 23 is accommodated inside the cylinder 40 when being at the standby position P2 illustrated in Figs. 3A and 4C. In addition, in the gas supply pipe 20, the most part except for the seal 23 is exposed from the cylinder 40 and is accommodated inside the film-forming chamber 11 when being at the film-forming position P1 illustrated in Fig. 4A.

The gas supply pipe 20 is formed of a material which is heat resistant and electrically insulative. The gas supply pipe 20 can be formed of a simple single pipe member and can be formed integrally with a cooling pipe. As this structure, for example, the gas supply pipe 20 can have a dual pipe structure, such that the inside of an inner pipe structure serves as a flow channel for a medium gas and the space between the inner pipe structure and an outer pipe structure serves as a flow channel in which the cooling water flows.

The gas supply pipe 20 is required to be insulative in order to maintain its form without melting even if the heat generating unit 30 generates heat of a high temperature exceeding 1,000°C during film-forming and to prevent an electric short-circuit with respect to the energized heat generating unit 30. A ceramic material satisfying the requirements can be used for the gas supply pipe 20. However, in consideration of cooling performance, it is preferable to use a ceramic material such as aluminum nitride, silicon carbide, silicon nitride, and aluminum oxide having high thermal conductivity. In addition, without being limited to the ceramic material, a metallic material such as stainless steel and a super heat-resistant alloy can be used for the gas supply pipe 20. In a case where a metallic material is used, its surface can be covered with the ceramic material described above.

### [Heat Generating Unit 30]

Subsequently, when power is received from a power source (not illustrated), the heat generating unit 30 generates heat and promotes decomposition of the medium gas supplied from the gas supply pipe 20 to the inside of the container P.

The heat generating unit 30 includes a heat generating body 31 and a pair of leads 33 of which the tip end side (lower end in Figs. 1A and 1B) is electrically connected to the heat generating body 31. The rear end side of the leads 32 is supported by the second seal ring 25, and the leads 32 move upward and downward following the gas supply pipe 20 moving upward and downward. It is preferable that the lengths of the heat generating body 31 and the leads 32 are set such that the heat generating body 31 occupies the inside of the container P in its entirety when the gas supply pipe 20 reaches the film-forming position P1.

In the heat generating unit 30, a part carrying out heat generation required to form a film is the heat generating body 31, and the leads 32 function only as electric wires in which power from the power source flows toward the heat generating body 31. That is, in the heat generating unit 30, only the heat generating body 31 part can be selectively caused to generate heat. The lower end portion of the heat generating body 31 can be formed in a coil shape in order to increase the opportunity of contact with the supplied medium gas G.

The heat generating body 31 is formed in a U-shape which is folded back in the vicinity of the nozzle 28. Therefore, the medium gas G supplied from the gas supply pipe 20 is sprayed to this folded-back part without leaking.

The heat generating body 31 generates heat by being energized. In order to efficiently decompose the medium gas, the temperature of heat-generation is set within a range from 1, 550°C to 2,400°C. Therefore, the heat generating body 31 is formed of a material containing one or more metallic elements selected from the group consisting of tungsten (W), molybdenum (Mo), zirconium (Zr), tantalum (Ta), vanadium (V), niobium (Nb), and hafnium (Hf) known as high-melting metals. As the material, a pure metal, an alloy, or a metal carbide formed of the metallic elements can be selected. Among the metallic elements, a material containing one or more metallic elements selected from the group consisting of Mo, W, Zr, and Ta is preferably employed.

The leads 32 are formed of a material having low electric resistance, for example, copper, aluminum, and an alloy thereof.

In the present embodiment, the heat generating unit 30 is heated by being energized. However, as long as the medium gas G can be decomposed, the heat generation method for the heat generating body in the present invention is not limited to energizing and heating.

### [Cylinder 40]

As illustrated in Figs. 1A and 1B, the cylinder 40 is fixed in a state of being erected from the upper chamber 13 when the lower end is inserted into the through-window 17.

The cylinder 40 includes a cylinder main body 41 and the pressure-reducing chamber 43 which is provided inside the cylinder main body 41. As described above, the cylinder main body 41 penetrates the through-window 17 of the upper chamber 13. When the pipe main body 21 of the gas supply pipe 20 moves upward and downward in the pressure-reducing chamber 43, the pipe main body 21 advances and retreats with respect to the film-forming chamber 11. The pressure-reducing chamber 43 occupies a region lower than the seal 23, and the volume of the pressure-reducing chamber 43 continuously changes in accordance with the pipe main body 21 moving upward and downward. At this time, the cylinder main body 41 also functions to guide upward/downward movement of the gas supply pipe 20.

An exhaust port 45 through which the pressure-reducing chamber 43 and the outside of the cylinder main body 41 communicate with each other is provided in the cylinder main body 41, and the exhaust port 45 is connected to the exhaust pump (not illustrated). When the exhaust pump operates on the premise that the shielding gate 18 is closed, the pressure-reducing chamber 43 is in a pressure-reduced state, and preferably in a vacuum state (for example, within a range approximately from 2×10⁻² to 8×10⁻² Torr). When the gas supply pipe 20 is at the standby position P2, the first gas flow channel 22 communicates with the pressure-reducing chamber 43 of the cylinder 40. When the pressure in the pressure-reducing chamber 43 is reduced, the first gas flow channel 22 is in a pressure-reduced state.

An gas supply port 47 causing the pressure-reducing chamber 43 and the outside of the cylinder main body 41 to be in communication with each other is provided in the cylinder main body 41. The gas supply port 47 and the raw material tank 29 storing the medium gas G are connected to each other via a piping 49, and the medium gas G stored in the raw material tank 29 is supplied to the pressure-reducing chamber 43 in response to an opening-closing operation of an opening-closing valve V1.

The volumes of the pressure-reducing chamber 43 is minimized when the gas supply pipe 20 is at the film-forming position P1 (Fig. 1B) and is maximized when the gas supply pipe 20 is at the standby position P2 (Fig. 1A).

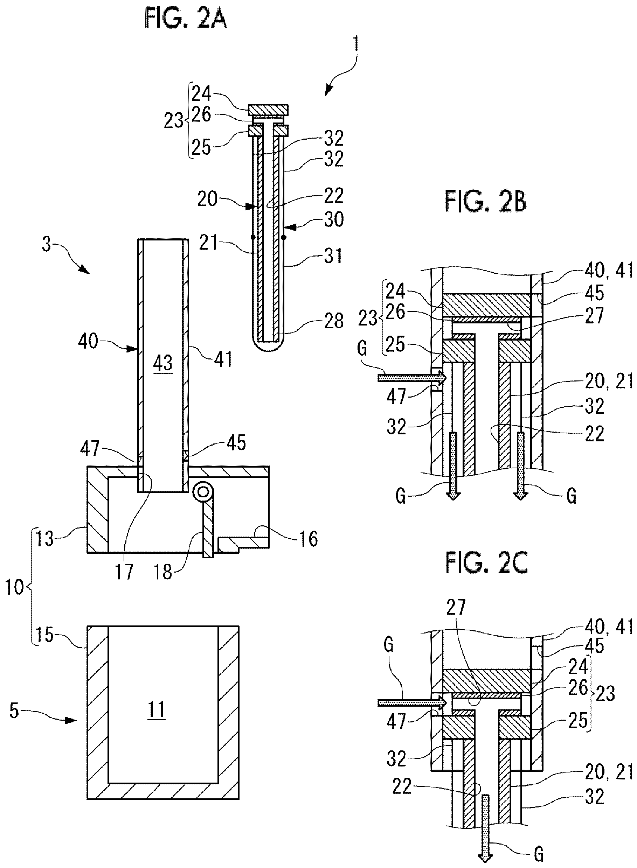

When the gas supply pipe 20 is at the film-forming position P1, as illustrated in Fig. 2C, the position of the spacer 26 of the seal 23 in a horizontal direction coincides with the gas supply port 47 of the cylinder 40. Therefore, the medium gas G supplied from the raw material tank 29 passes successively through the piping 49, the gas supply port 47, and the second gas flow channel 27 of the spacer 26 and flows into the first gas flow channel 22 of the pipe main body 21.

Meanwhile, when the gas supply pipe 20 is at a position other than the film-forming position P1, as illustrated in Fig. 2B, the gas supply port 47 of the cylinder 40 is positioned lower than the second seal ring 25 of the seal 23. Therefore, the medium gas G supplied from the raw material tank 29 passes successively through the piping 49 and the gas supply port 47 and flows into a gap between the pipe main body 21 and the cylinder main body 41. At this time, the second gas flow channel 27 is closed.

### [Procedure of Film-forming]

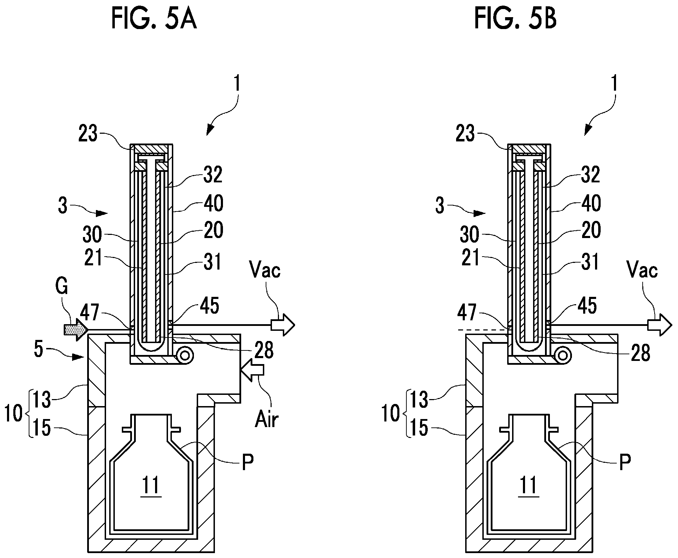

Subsequently, an example of a series of procedures for forming a barrier film in the container P by using the film forming device 1 will be described with reference to Figs. 3A to 5B. In Figs. 3A to 5B, a part of the elements of the film forming device 1 is omitted.

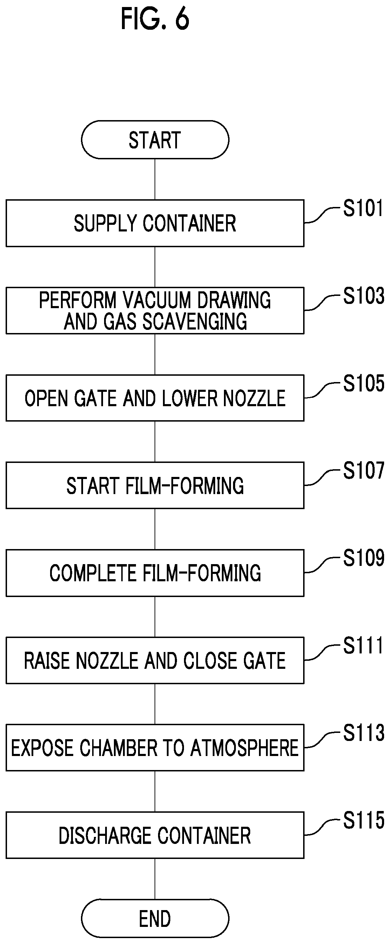

### [Step of Container Supplying (Fig. 3A, S101 in Fig. 6)]

When the container P formed in an upstream step is transported to the film forming device 1, the container P is accommodated in the film-forming chamber 11 of the lower chamber 15 being on standby at a position which has sufficiently retreated from the upper chamber 13. Thereafter, the lower chamber 15 abuts the upper chamber 13, and the film-forming chamber 11 is held in an air tight manner with respect to the outside.

At this time, the gas supply pipe 20 is placed at the standby position P2 which has retreated from the vacuum chamber 10. The pressure-reducing chamber 43 is in the widest state. In addition, the shielding gate 18 closes the opening of the cylinder 40, and the pressure-reducing chamber 43 forms a closed space except for the exhaust port 45.

In addition, at this time, the gas supply pipe 20 (first gas flow channel 22) is subjected to vacuum drawing Vac through the pressure-reducing chamber 43 by means of the exhaust pump (not illustrated). This vacuum drawing Vac continues to the next step.

### [Step of Vacuum Drawing and Gas Scavenging (Fig. 3B, S103 in Fig. 6)]

Subsequently, the exhaust pump (not illustrated) is operated so that the film-forming chamber 11 and the pressure-reducing chamber 43 are subjected to the vacuum drawing Vac, thereby being prepared for film-forming. At the same time as the vacuum drawing Vac of the pressure-reducing chamber 43, the medium gas G stored in the raw material tank 29 is supplied toward the pressure-reducing chamber 43. The supplied medium gas G passes successively through the piping 49 and the gas supply port 47, thereby reaching the pressure-reducing chamber 43 between the pipe main body 21 and the cylinder main body 41. Since the tip end of the cylinder main body 41 is closed by the shielding gate 18, the supplied medium gas G is discharged out of the system in a manner of pushing out air contained in the pressure-reducing chamber 43. When both the vacuum drawing and supplying of the medium gas G are continuously performed, the inside of the pressure-reducing chamber 43 is scavenged by the medium gas G, and it is possible to minimize the remaining air.

### [Opening Gate and Lowering Nozzle (Fig. 3C, S105 in Fig. 6)]

After both the vacuum drawing and supplying of the medium gas G are performed as much as a predetermined time, at the same time as opening of the shielding gate 18, the gas supply pipe 20 starts to move downward. The gas supply pipe 20 moves downward until the gas supply pipe 20 reaches the film-forming position P1 (Fig. 3A). In addition, at the same time as opening of the shielding gate 18, vacuum drawing from the cylinder main body 41 stops. Meanwhile, the vacuum drawing Vac of the film-forming chamber 11 continues. At this point of time, the medium gas G continues to be supplied. Since the shielding gate 18 is opened, the medium gas G filling the pressure-reducing chamber 43 flows into the vacuum chamber 10.

The exhaust pump continues to discharge air until the inside of the film-forming chamber 11 reaches a desired degree of vacuum. The degree of vacuum at this time ranges approximately from 10⁻¹ to 10⁻⁵ Torr.

The air in the pressure-reducing chamber 43 of the cylinder 40 may be discharged in the step of container feeding or the step of vacuum chamber closing prior to the step of vacuum drawing. The degree of vacuum at this time ranges approximately from 10⁻¹ to 10⁻⁵ Torr similar to the degree of vacuum of the film-forming chamber 11.

### [Completion of Nozzle Lowering and Start of Film Forming (Fig. 4A, S107 in Fig. 6)]

When the gas supply pipe 20 moves downward until the gas supply pipe 20 reaches the film-forming position P1, and when the film-forming chamber 11 reaches the desired degree of vacuum, power is supplied from the power source (not illustrated) such that the heat generating body 31 of the heat generating unit 30 generates heat.

When power is supplied to the heat generating unit 30, the film forming device 1 shifts from a standby period or a standby state to a film forming period or a film-forming state. Since the spacer 26 of the seal 23 is aligned with the gas supply port 47 of the cylinder main body 41, the medium gas G supplied from the raw material tank 29 passes successively through the gas supply port 47, the second gas flow channel 27 of the spacer 26, and the first gas flow channel 22 of the pipe main body 21, thereby being sprayed into the container P. The sprayed medium gas G comes into contact with the heat generating body 31 when passing through the heat generating body 31. Consequently, the medium gas G is decomposed and chemical species are generated. When the chemical species reach the inner surface of the container P, a barrier film is then formed. The vacuum drawing Vac continues while film-forming is performed.

### [Completion of Film Forming (Fig. 4B, S109 in Fig. 6)]

When a predetermined film forming operation is completed, power stops being supplied to the heat generating unit 30. However, supplying of the medium gas G and the operation (Vac) of the exhaust pump continue. The medium gas G is continuously supplied so that the medium gas G is sprayed to the heat generating body 31 even after film-forming. Therefore, the heat generating body 31 can be prevented from being in contact with air.

When power stops being supplied to the heat generating unit 30, film-forming is completed. The film forming device 1 shifts from the film forming period or the film-forming state to the standby period or the standby state.

### [Completion of Nozzle Raising and Gate Closing (Fig. 4C, Sill in Fig. 6)]

After completion of film-forming, the gas supply pipe 20 is caused to further retreat. When the gas supply pipe 20 reaches the standby position P2, the shielding gate 18 is closed. Since the inner walls of the seal 23 and the cylinder main body 41 are in tight contact with other, the pressure-reducing chamber 43 of the cylinder 40 forms a closed space.

Supplying of the medium gas G and the vacuum drawing Vac of the film-forming chamber 11 still continue at this time.

### [Atmosphere Exposing (Fig. 5A, S113 in Fig. 6)]

When the shielding gate 18 is closed, the film-forming chamber 11 of the vacuum chamber 10 is exposed to the atmosphere.

Although the vacuum drawing Vac of the film-forming chamber 11 stops before atmosphere exposing Air, supplying of the medium gas G is continuously performed. However, in order to avoid a pressure rise of the pressure-reducing chamber 43, the vacuum drawing Vac of the pipe main body 21 of the gas supply pipe 20 is performed.

### [Container Discharging (Fig. 5B, S115 in Fig. 6)]

After the lower chamber 15 moves downward to a required position, the container P having a barrier film formed therein is transferred toward a downstream step by means of appropriate transportation means. The film forming device 1 is in a standby state until another container P (next processing subject) is transferred. In the standby state, the vacuum drawing Vac of the pressure-reducing chamber 43 continues.

### [Operation and Effect]

Subsequently, effects realized by the film forming device 1 will be described.

Here, the film forming device 1 moves upward and downward as much as a stroke corresponding to an extent that the pipe main body 21 advances and retreats in the film-forming chamber 11. In a case of using the raw material tank 29 of which the position is fixed, a gas supply path leading from the raw material tank 29 to the pipe main body 21 requires a portion which absorbs this upward/downward movement. When a piping in which a pipe formed of a flexible raw material such as a resin is spirally wound is used between the pipe main body 21 and the raw material tank 29, the upward/downward movement can be absorbed. However, since the pipe main body 21 is disposed in the pressure-reducing chamber 43 to be subjected to vacuum drawing, at least a part of the flexible piping connected to the pipe main body 21 is placed in the pressure-reducing chamber 43 to be subjected to vacuum drawing. Since a flexible raw material has ventilation properties, the medium gas G leaks out of the piping, particularly in an environment of vacuum drawing. In such a condition, the medium gas G cannot be satisfactorily supplied to the inside of the container P. Therefore, in the present embodiment, without using a flexible raw material, a structure of absorbing upward/downward movement is employed.

That is, in the gas transportation portion 5 of the present embodiment, the gas supply pipe 20 is accommodated in the cylinder 40 so as to be able to move upward and downward. When the pipe main body 21 moves downward to the film-forming position P1, the position of the second gas flow channel 27 of the seal 23 coincides with the gas supply port 47 of the cylinder 40, so that the medium gas G can be supplied from the pipe main body 21 to the container P. Meanwhile, including the standby position P2, when the pipe main body 21 is placed at a position other than the film-forming position P1, the medium gas G can be supplied to the pressure-reducing chamber 43 around the pipe main body 21. In this manner, the gas supply pipe 20 and the cylinder 40 behave as a piston-cylinder mechanism, and the gas transportation portion 5 can be produced with a raw material such as a metallic material allowing no gas to pass through, the medium gas G can be prevented from leaking.

Furthermore, in the present embodiment, at a position other than the film-forming position P1, since the pressure-reducing chamber 43 can be filled with the medium gas G, the film-forming chamber 11 can be scavenged prior to the step of film-forming, in addition to that the pressure-reducing chamber 43 can be scavenged, thereby being useful for reducing oxygen and nitrogen inside the system.

Subsequently, according to the film forming device 1, the first gas flow channel 22 of the gas supply pipe 20 can be prevented in advance from being shut down.

That is, when the vacuum chamber 10 is exposed to the atmosphere after a barrier film is formed, particles (minute peeling pieces) are generated on surfaces of components equal to the barrier film adhered inside the gas supply pipe 20 or the vacuum chamber 10, so that the particles can invade the first gas flow channel 22, resulting in a shut-down. In addition, in a case where the medium gas G reacts to oxygen or moisture in the atmosphere and compounds can be generated, these compounds will cause a shut-down of the gas flow channels, similar to the particles.

Incidentally, according to the film forming device 1, since the first gas flow channel 22 is subjected to vacuum drawing while being on standby, the particles or the compounds do not invade the first gas flow channel 22.

As described above, according to the film forming device 1, the gas supply pipe 20 required for forming a barrier film can be maintained in a sound state. Therefore, according to the film forming device 1, the frequency of maintenance for a shut-down of the gas supply pipe 20 is reduced, so that a continuous operation for a long period of time can be ensured.

Subsequently, according to the film forming device 1, the heat generating unit 30 can be prevented from breaking due to reaction to nitrogen, oxygen, or the like.

Since the temperature of the heat generating unit 30 becomes high exceeding 1,000°C while forming a barrier film, even though film-forming ends and the heat generating unit 30 stops being energized, a considerably high temperature is maintained. Therefore, when this heat generating unit 30 in a high-temperature state comes into contact with the atmosphere, parts in the vicinity of the surface of the heat generating unit 30 react to mainly nitrogen and oxygen in the atmosphere, and there is concern that the heat generating unit 30 falls into a breakage state where the original function is extinguished.

Incidentally, according to the film forming device 1, after film-forming, since the heat generating unit 30 is accommodated in the pressure-reducing chamber 43 which has been subjected to vacuum exhaust together with the gas supply pipe 20. Accordingly, reaction to nitrogen, oxygen, or the like is suppressed, and the heat generating unit 30 can be maintained in a sound state. Therefore, according to the film forming device 1, the frequency of maintenance for the heat generating unit 30 is reduced, so that a continuous operation for a long period of time can be ensured.

Subsequently, according to the film forming device 1, as means for reducing pressure in the first gas flow channel 22 of the gas supply pipe 20, the cylinder 40 having the pressure-reducing chamber 43 is provided, and the pressure in the first gas flow channel 22 is reduced via the pressure-reducing chamber 43. Since the position of the cylinder 40 is fixed, a mechanism for reducing pressure can be simplified. Furthermore, since the cylinder 40 functions as a guide for moving the gas supply pipe 20 upward and downward, there is no need to separately provide a guiding mechanism for the gas supply pipe 20. Moreover, since it is sufficient for the pressure-reducing chamber 43 to have a minimum space required for the gas supply pipe 20 to move upward and downward, the time required to reduce the pressure in the second gas flow channel 27 can be minimized. Moreover, it is sufficient for the cylinder 40 to have a minimum space only for accommodating the gas supply pipe 20. Therefore, the pressure-reduced state of the pressure-reducing chamber 43 inside the cylinder 40 can be easily maintained.

In addition, in the film forming device 1, the cylinder 40 is attached to the upper chamber 13, and the pressure-reducing chamber 43 communicates with the film-forming chamber 11. In this manner, in the film forming device 1, since the cylinder 40, in which the pipe main body 21 is accommodated so as to be able to move upward and downward, is directly connected to the vacuum chamber 10 without passing through the piping, the configuration of the device can be simple and compact.

Hereinabove, a preferable embodiment of the present invention has been described. Unless the configuration departs from the gist of the present invention, the configurations exemplified in the embodiment described above can be selectively adopted and abandoned or suitably changed to a different configuration.

The embodiment described above has illustrated an example in which the second gas flow channel 27 is provided in the spacer 26 of the seal 23. However, the second gas flow channel of the present invention is not limited thereto. The form is arbitrary as long as the gas supply port 47 of the cylinder 40 and the first gas flow channel 22 can communicate with each other at the film-forming position P1. For example, a second gas flow channel can be provided in the seal ring itself.

In addition, the position where the gas supply port 47 and the first gas flow channel 22 communicate with each other is not limited to only the film-forming position P1. That is, the present invention is acceptable as long as the gas supply port 47 and the first gas flow channel 22 communicate with each other at least at the film-forming position P1. The gas supply port 47 and the first gas flow channel 22 may communicate with each other before and after the position.

In addition, in the embodiment described above, although power stops being supplied to the heat generating unit 30 and film-forming ends, the medium gas G continues to be supplied. However, the medium gas G can stop being supplied to the gas supply pipe 20. In this case, even after power stops being supplied to the heat generating unit 30, the heat generating unit 30 is in a high temperature region. Accordingly, it is preferable that the medium gas G continues to be supplied because oxidation or the like of the heat generating body 31 can be prevented by spraying the medium gas G to the heat generating body 31. However, if the heat generating body 31 can be cooled to the extent that oxidation or the like does not occur, the medium gas G can stop being supplied after film-forming ends.

In addition, the embodiment described above has illustrated an example of using an oscillating-type shielding gate 18 for partitioning the chamber into the film-forming chamber 11 and the pressure-reducing chamber 43. However, a sliding-type shielding gate can be used.

In addition, the embodiment described above has illustrated the cylinder 40 remaining the minimum space required for moving the gas supply pipe 20 upward and downward. However, the present invention is not limited thereto. A cylinder having room with respect to the gas supply pipe 20 may be employed. In this case, when the pressure-reducing chamber 43 is enlarged more than that is required, it takes time to reduce pressure and discharge air. Therefore, it is preferable to reduce the volume as much as possible. Depending on the size of the container P to be subjected to film-forming, it is preferable that the volume of the pressure-reducing chamber 43 is equal to or smaller than that of the film-forming chamber 11.

In addition, a resin configuring the container P used in the present invention is arbitrary. Examples of the resin include a polyethylene terephthalate resin (PET), a polybutylene terephthalate resin, a polyethylene naphthalate resin, a polyethylene resin, a polypropylene resin (PP), and a cycloolefin copolymer resin (COC, cyclic olefin copolymerization).

In addition, the usage of the container used in the present invention is arbitrary. For example, the container can be widely used as a container accommodating beverages such as water, tea drinks, soft drinks, carbonated drinks, and fruit juice drinks; and food in liquid, viscous body, powder, or solid form.

In addition, the material of a barrier film is also arbitrary. It is possible to apply various kinds of materials such as substances which can form a film by using the medium gas G through the CVD method, typically, a carbon film, a silica film, and an alumina film.

An amorphous carbon film is a specific example of a carbon film. The amorphous carbon film is a carbon film having a structure in an amorphous state in which diamond components (bond of carbon atoms is SP³ bond), graphite components (bond of carbon atoms is SP² bond), and polymer components (bond of carbon atoms is SP¹ bond) are mixed. The amorphous carbon film denotes a film of which hardness varies due to a change of the abundance ratio of binding components of the carbon atoms thereof, including a hard carbon film and a soft carbon film. In addition, the amorphous carbon film also includes a hydrogenated amorphous carbon containing hydrogen. Moreover, a hard carbon film also includes an amorphous DLC film having SP³ bonds as main bodies.

In addition, as alternative barrier films, it is possible to use a SiOx film, an AlOx film, a hydrogen containing SiNx film, a hydrogen containing DLC film, a hydrogen containing SiOx film, a hydrogen containing SiCxNy film, and the like.

### Reference Signs List

- 1: FILM FORMING DEVICE
- 3: FILM-FORMING PORTION
- 5: GAS TRANSPORTATION PORTION
- 10: VACUUM CHAMBER
- 11: FILM-FORMING CHAMBER
- 13: UPPER CHAMBER
- 14: ENTRY WAY
- 15: LOWER CHAMBER
- 16: EXHAUST PASSAGE
- 17: THROUGH-WINDOW
- 18: SHIELDING GATE
- 20: GAS SUPPLY PIPE
- 21: PIPE MAIN BODY
- 22: FIRST GAS FLOW CHANNEL
- 23: SEAL
- 24: FIRST SEAL RING
- 25: SECOND SEAL RING
- 26: SPACER
- 27: SECOND GAS FLOW CHANNEL
- 28: NOZZLE
- 29: RAW MATERIAL TANK
- 30: HEAT GENERATING UNIT
- 31: HEAT GENERATING BODY
- 32: LEAD
- 40: CYLINDER
- 41: CYLINDER MAIN BODY
- 43: PRESSURE-REDUCING CHAMBER
- 45: EXHAUST PORT
- 47: GAS SUPPLY PORT
- 49: PIPING
- G: MEDIUM GAS
- P: CONTAINER
- P1: FILM-FORMING POSITION
- P2: STANDBY POSITION
- V1: OPENING-CLOSING VALVE

## Claims

1. A film forming device (1) comprising:
a chamber (10) which has a film-forming chamber (11) accommodating a container (P) for forming a gas barrier film, and in which the film-forming chamber (11) is configured to be in a vacuum state when the gas barrier film is formed;
a gas supply pipe (20) which has a first gas flow channel (22) which is configured to introduce a medium gas (G) used for forming the gas barrier film into the container (P) and which is configured to move upward and downward along an axis line direction thereof;
a cylinder (40) in which the gas supply pipe (20) is configured to move upward and downward; and
a heat generating body (31) which is configured to heat when power is supplied,
wherein the cylinder (40) has a gas supply port (47) which is configured to supply the medium gas (G) from outside,
wherein the gas supply pipe (20) includes a second gas flow channel (27) which is configured to move upward and downward between a film-forming position (P1) where film-forming is performed and a standby position (P2) where no film-forming is performed, and is configured to cause the gas supply port (47) of the cylinder (40) and the first gas flow channel (22) to be in communication with each other at the film-forming position (P1),
**characterized in that**
the film forming device (1) further comprises a shielding gate (18), which is configured to block communication between the film-forming chamber (11) and the first gas flow channel (22) when the gas supply pipe (20) is retreated from the film-forming chamber (11),
the second gas flow channel (27) is provided in a seal (23) which is fitted into the gas supply pipe (20) and is slidably pressed to the cylinder (40),
the seal (23) includes a first seal ring (24), a second seal ring (25) which is provided at a distance from the first seal ring (24) in the axis line direction, and a spacer (26) which is provided between the first seal ring (24) and the second seal ring (25) and has a diameter smaller than diameters of the first seal ring (24) and the second seal ring (25), and
the second gas flow channel (27) is provided in the spacer (26).

2. The film forming device according to Claim 1, further comprising:
a heat generating unit (30) which is supported by the gas supply pipe (20),
wherein the heat generating unit (30) has the heat generating body (31) which is configured to generate heat when power is supplied and a pair of leads (32) which is electrically connected to the heat generating body (31).

3. The film forming device according to Claim 1 or 2,
wherein the gas supply pipe (47) is configured to retreat from the film-forming chamber (11) and is configured to be accommodated in the cylinder while being on standby before gas barrier film (47) is formed, and the first gas flow channel (22) is configured to be subjected to vacuum drawing.

4. The film forming device according to Claim 1 or 3,
wherein the medium gas (G) is configured to be supplied to the film-forming chamber (11) via the gas supply pipe (20) continuously as much as a predetermined period of time after forming of the gas barrier film ends.

5. The film forming device according to any one of Claims 1, 3 and 4,
wherein the medium gas (G) is configured to be supplied to the first gas flow channel (22) between the gas supply pipe (20) and the cylinder (40) via the gas supply port (47) while being configured to be on standby before forming of the gas barrier film is performed.

## Patentansprüche

1. Filmbildungsvorrichtung (1), die Folgendes umfasst:
eine Kammer (10), die eine Filmbildungskammer (11) aufweist, die einen Behälter (P) zum Bilden eines Gassperrfilms unterbringt, und wobei die Filmbildungskammer (11) dazu konfiguriert ist, sich in einem Vakuumzustand zu befinden, wenn der Gassperrfilm gebildet wird;
ein Gaszufuhrrohr (20), das einen ersten Gasströmungskanal (22) aufweist, der dazu konfiguriert ist, ein Mediumgas (G), das zum Bilden des Gassperrfilms verwendet wird, in den Behälter (P) einzuführen, und das dazu konfiguriert ist, sich entlang einer Achsenlinie davon in Richtung nach oben und nach unten zu bewegen;
einen Zylinder (40), in dem das Gaszufuhrrohr (20) dazu konfiguriert ist, sich nach oben und nach unten zu bewegen; und
einen Wärmegenerierungskörper (31), der dazu konfiguriert ist, sich zu erwärmen, wenn Leistung zugeführt wird,
wobei der Zylinder (40) eine Gaszufuhröffnung (47) aufweist, die dazu konfiguriert ist, das Mediumgas (G) von außen zuzuführen,
wobei das Gaszufuhrrohr (20) einen zweiten Gasströmungskanal (27) beinhaltet, der dazu konfiguriert ist, sich zwischen einer Filmbildungsposition (P1), in der das Filmbilden durchgeführt wird, und einer Bereitschaftsposition (P2), in der kein Filmbilden durchgeführt wird, nach oben und nach unten zu bewegen, und dazu konfiguriert ist, die Gaszufuhröffnung (47) des Zylinders (40) und den ersten Gasströmungskanal (22) zu veranlassen, miteinander an der Filmbildungsposition (P1) in Kommunikation zu stehen,
**dadurch gekennzeichnet, dass**
die Filmbildungsvorrichtung (1) weiter ein Abschirmungs-Gate (18) umfasst, das dazu konfiguriert ist, Kommunikation zwischen der Filmbildungskammmer (11) und dem ersten Gasströmungskanal (22) zu blockieren, wenn das Gaszufuhrrohr (20) aus der Gasbildungskammer (11) zurückgezogen ist,
der zweite Gasströmungskanal (27) in einer Dichtung (23) bereitgestellt ist, die in das Gaszufuhrrohr (20) gepasst und gleitend zu dem Zylinder (40) gedrückt ist,
die Dichtung (23) einen ersten Dichtring (24), einen zweiten Dichtring (25), der in einem Abstand von dem ersten Dichtring (24) in der Achsenlinienrichtung bereitgestellt ist, und einen Abstandhalter (26) beinhaltet, der zwischen dem ersten Dichtring (24) und dem zweiten Dichtring (25) bereitgestellt ist und einen Durchmesser aufweist, der kleiner ist als Durchmesser des ersten Dichtrings (24) und des zweiten Dichtrings (25), und
der zweite Gasströmungskanal (27) in dem Abstandhalter (26) bereitgestellt ist.

2. Filmbildungsvorrichtung nach Anspruch 1, die weiter Folgendes umfasst:
eine Wärmegenerierungseinheit (30), die von dem Gaszufuhrrohr (20) getragen wird,
wobei die Wärmegenerierungseinheit (30) den Wärmegenerierungskörper (31) aufweist, der dazu konfiguriert ist, Wärme zu generieren, wenn Leistung zugeführt wird, und ein Paar von Leitern (32), das elektrisch mit dem Wärmegenerierungskörper (31) verbunden ist.

3. Filmbildungsvorrichtung nach Anspruch 1 oder 2,
wobei das Gaszufuhrrohr (47) dazu konfiguriert ist, sich von der Filmbildungskammmer (11) zurückzuziehen, und dazu konfiguriert ist, in dem Zylinder untergebracht zu werden, während es in Bereitschaft ist, bevor Gassperrfilm (47) gebildet wird, und der erste Gasströmungskanal (22) dazu konfiguriert ist, Vakuumabziehen unterzogen zu werden.

4. Filmbildungsvorrichtung nach Anspruch 1 oder 3,
wobei das Mediumgas (G) dazu konfiguriert ist, zu der Filmbildungskammmer (11) über das Gaszufuhrrohr (20) kontinuierlich bis zu einer vorbestimmten Zeitspanne, nachdem das Bilden der Gassperrfolie endet, zugeführt zu werden.

5. Filmbildungsvorrichtung nach einem der Ansprüche 1, 3 und 4,
wobei das Gasmedium (G) dazu konfiguriert ist, zu dem ersten Gasströmungskanal (22) zwischen dem Gaszufuhrrohr (20) und dem Zylinder (40) über die Gaszufuhröffnung (47) zugeführt zu werden, während es dazu konfiguriert ist, in Bereitschaft zu sein, bevor das Bilden der Gassperrfolie durchgeführt wird.

## Revendications

1. Dispositif de formation de film (1) comprenant :
une chambre (10) qui présente une chambre de formation de film (11) recevant un récipient (P) pour former un film barrière aux gaz, et dans laquelle la chambre de formation de film (11) est configurée pour être dans un état de vide lorsque le film barrière aux gaz est formé ;
un tuyau d'alimentation en gaz (20) qui présente un premier canal d'écoulement de gaz (22) pour introduire un gaz porteur (G) utilisé pour former le film barrière aux gaz dans le récipient (P) et qui est configuré pour se déplacer vers le haut et vers le bas le long d'une direction de son axe ;
un cylindre (40) dans lequel le tuyau d'alimentation en gaz (20) est configuré pour se déplacer vers le haut et vers le bas ; et
un corps générant de la chaleur (31) qui est configuré pour chauffer lorsque de l'énergie est fournie,
dans lequel le cylindre (40) présente un orifice d'alimentation en gaz (47) qui est configuré pour fournir le gaz porteur (G) depuis l'extérieur,
dans lequel le tuyau d'alimentation en gaz (20) inclut un second canal d'écoulement de gaz (27) qui est configuré pour se déplacer vers le haut et vers le bas entre une position de formation de film (P1) où la formation de film est effectuée et une position d'attente (P2) où aucune formation de film n'est effectuée et est configuré pour amener l'orifice d'alimentation en gaz (47) du cylindre (40) et le premier canal d'écoulement de gaz (22) à être en communication l'un avec l'autre à la position de formation de film (P1),
**caractérisé en ce que**
le dispositif de formation de film (1) comprend en outre une porte de blindage (18) qui est configurée pour bloquer la communication entre la chambre de formation de film (11) et le premier canal d'écoulement de gaz (22) lorsque le tuyau d'alimentation en gaz (20) est retiré de la chambre de formation de film (11),
le second canal d'écoulement de gaz (27) est fourni dans un joint (23) qui est installé dans le tuyau d'alimentation en gaz (20) et est pressé de manière coulissante contre le cylindre (40),
le joint (23) inclut une première bague d'étanchéité (24), une seconde bague d'étanchéité (25) qui est fournie à une distance de la première bague d'étanchéité (24) dans la direction de l'axe, et une entretoise (26) qui est fournie entre la première bague d'étanchéité (24) et la seconde bague d'étanchéité (25) et présente un diamètre inférieur à des diamètres de la première bague d'étanchéité (24) et de la seconde bague d'étanchéité (25), et
le second canal d'écoulement de gaz (27) est fourni dans l'entretoise (26).

2. Dispositif de formation de film selon la revendication 1, comprenant en outre :
une unité de génération de chaleur (30) qui est supportée par le tuyau d'alimentation en gaz (20),
dans lequel l'unité de génération de chaleur (30) présente le corps générant de la chaleur (31) qui est configuré pour générer de la chaleur lorsque l'alimentation est fournie et une paire de conducteurs (32) qui est électriquement connectée au corps générant de la chaleur (31).

3. Dispositif de formation de film selon la revendication 1 ou 2,
dans lequel le tuyau d'alimentation en gaz (47) est configuré pour se retirer de la chambre de formation de film (11) et est configuré pour être reçu dans le cylindre tout en étant en attente avant que le film barrière aux gaz (47) soit formé, et le premier canal d'écoulement de gaz (22) est configuré pour être soumis à un étirage sous vide.

4. Dispositif de formation de film selon la revendication 1 ou 3,
dans lequel le gaz porteur (G) est configuré pour être fourni à la chambre de formation de film (11) par l'intermédiaire du tuyau d'alimentation en gaz (20) aussi longtemps qu'une période de temps prédéterminée après la formation des extrémités de film barrière aux gaz.

5. Dispositif de formation de film selon l'une quelconque des revendications 1, 3 et 4,
dans lequel le gaz porteur (G) est configuré pour être fourni au premier canal d'écoulement de gaz (22) entre le tuyau d'alimentation en gaz (20) et le cylindre (40) par l'intermédiaire de l'orifice d'alimentation en gaz (47) tout en étant configuré pour être en attente avant que la formation du film barrière aux gaz soit effectuée.
